Europäisches Patentamt

**European Patent Office**

Office européen des brevets

(19)

(11) Numéro de publication : **0 065 455**
**B1**

(12) **FASCICULE DE BREVET EUROPÉEN**

(45) Date de publication du fascicule du brevet :
**21.11.85**

(51) Int. Cl.⁴ : **G 01 R 29/10**

(21) Numéro de dépôt : **82400829.6**

(22) Date de dépôt : **05.05.82**

(54) **Procédé et dispositif pour l'analyse d'un faisceau de rayonnement d'ondes électromagnétiques hyperfréquence.**

(30) Priorité : **18.05.81 FR 8109855**

(43) Date de publication de la demande :
**24.11.82 Bulletin 82/47**

(45) Mention de la délivrance du brevet :
**21.11.85 Bulletin 85/47**

(84) Etats contractants désignés :
**DE GB**

(56) Documents cités :
**AU-A-  508 205**
**FR-A- 1 473 881**
**US-A- 3 708 796**
**US-A- 3 825 931**

(73) Titulaire : **SOCIETE D'ETUDE DU RADANT**
**Avenue de l'Atlantique Zone d'activités d'Orsay B.P. 39**
**F-91942 Les Ulis Cedex (FR)**

(72) Inventeur : **Sadones, Henri**
**8, rue des Eaux**
**F-75016 Paris (FR)**

(74) Mandataire : **Lerner, François**
**5, rue Jules Lefebvre**
**F-75009 Paris (FR)**

## Description

La présente invention a essentiellement pour objet un procédé et un dispositif permettant d'analyser point par point le faisceau de rayonnement d'ondes électromagnétiques hyperfréquence reçues sur une surface donnée. L'invention s'applique notamment à l'analyse d'un faisceau de telles ondes émis par une antenne émettrice hyperfréquence.

De telles analyses sont en particulier nécessaires pour la mise au point et l'utilisation des antennes émettrices.

On fait habituellement appel pour une telle analyse à l'un ou l'autre des deux procédés suivants.

1. On établit des diagrammes de rayonnement de l'antenne émettrice en utilisant d'autres antennes réceptrices placées comme l'antenne émettrice sur une base d'essai extérieure. Ce procédé ne peut être utilisé que dans la mesure où l'antenne émettrice et les antennes réceptrices qui permettront d'établir les diagrammes sont suffisamment éloignées (par exemple de 5 000 fois la longueur d'ondes pour une antenne d'envergure égale à 50 longueurs d'ondes, c'est-à-dire 500 mètres pour des fréquences de l'ordre de 3 000 MHz). D'autre part, les analyses ne sont valables dans de telles conditions que si le profil du terrain s'y prête ainsi que l'environnement qui ne doit pas provoquer de phénomènes de réflexion parasites responsables d'interférences. Il est évident qu'un tel procédé d'analyse se heurte à de grosses difficultés d'infrastructure pour sa mise en œuvre. En outre, ce procédé est très long, nécessitant plusieurs centaines d'heures de mesures pour la mise au point du diagramme d'une antenne émettrice.

2. Compte tenu de la lourdeur du procédé ci-dessus mentionné, on développe actuellement un procédé permettant de déduire le diagramme de rayonnement d'une antenne à partir des mesures du champ électromagnétique faites à proximité immédiate de l'antenne. Il s'agit donc d'un procédé indirect, la mesure du champ proche se faisant par l'intermédiaire d'une sonde extrêmement sensible que l'on déplace devant l'antenne à mesurer. La sonde elle-même peut être un guide ouvert ou un dipôle.

Les difficultés interviennent au niveau du système mécanique de déplacement de la sonde et de ses liaisons électriques avec le récepteur de mesure, lesquels provoquent des réflexions parasites perturbatrices que l'on tente d'éliminer en les protégeant par des systèmes absorbants, ce qui complique le système et en augmente l'encombrement.

En outre, les mesures doivent être faites en des points parfaitement repérés : le système mécanique de déplacement de la sonde doit être extrêmement précis.

Cependant, la limitation principale de ce procédé réside dans la lenteur du système de déplacement mécanique de la sonde.

Dans les systèmes actuels, cette vitesse ne dépasse pas 10 centimètres/seconde. Pour le contrôle d'une antenne hyperfréquence carrée fonctionnant à 3 000 MHz et ayant 50 longueurs d'onde de côté, le temps de mesure est ainsi de 5 heures.

L'invention a pour objet de permettre une mesure rapide précise et très économique permettant d'analyser le faisceau de rayonnement d'ondes électromagnétiques hyperfréquence reçu sur une surface donnée et s'appliquant notamment à l'analyse d'un faisceau de telles ondes émis par une antenne émettrice hyperfréquence, ne présentant aucun des inconvénients et des limitations des deux procédés connus susmentionnés.

Le nouveau procédé de l'invention part de l'idée d'exploiter de manière nouvelle un réseau connu de fils conducteurs interrompu de distance en distance par des interrupteurs contrôlables, tels en particulier que des diodes, présentant au moins deux états logiques (1,0) tel que passant ou non passant pour permettre une telle analyse quasiment ponctuelle.

Un tel réseau, connu du brevet US-A-3 708 796 (ou FR-A 2 063 967) permet de constituer des lentilles électroniques actives pour assurer le balayage d'un faisceau d'onde hyperfréquence, tombant sur la lentille. En divisant le réseau en bandes rectilignes et utilisant plusieurs réseaux superposés, on peut obtenir des déflexions du faisceau dans un plan perpendiculaire aux fils.

Le procédé d'analyse conforme à l'invention se caractérise en ce qu'on place sur le trajet dudit faisceau que l'on veut analyser un réseau, en soi connu orienté parallèlement au vecteur champ électrique de l'onde incidente, de fils conducteurs, interrompus de distance en distance par des interrupteurs contrôlables, tels en particulier que des diodes présentant au moins deux états logiques (1,0) tels que passant ou non passant, on organise ce réseau de façon à pouvoir commander simultanément le plus grand nombre desdits éléments dans un premier état (1) et un nombre restreint et géographiquement groupé des autres éléments « minoritaires » dans l'autre état (0), on fait varier séquentiellement et électroniquement la position desdits éléments commandés dans l'état zéro pour balayer sensiblement toute la surface du réseau, et l'on reçoit et exploite le signal d'écho reçu sur un détecteur en repérant les caractéristiques significatives de cet écho en relation chaque fois avec la position desdits éléments en nombre restreint. Avantageusement, pour affiner la mesure et se dégager du « bruit » ambiant, on module le courant traversant lesdits éléments minoritaires pour obtenir un signal d'écho modulé en correspondance plus aisément discernable.

Contrairement donc à l'utilisation du réseau prévue au brevet susmentionné US-A 3 708 796, on ne travaille pas par bandes rectilignes pour défléchir le faisceau reçu, mais on perturbe simplement localement le signal qui traverse le réseau et l'on promène rapidement cette perturbation sur toute la surface du réseau, de manière à introduire une discrimination locale et repérable du faisceau, d'où seront déduites les caractéristiques d'analyse.

On comprend immédiatement que l'analyse du faisceau peut se faire en tous points de son parcours, et par exemple à proximité proche d'une antenne émettrice s'il s'agit d'analyser le faisceau d'émission de cette antenne. On comprend d'autre part que la « sonde » étant constituée suivant l'invention par les éléments « minoritaires » mentionnés qui sont physiquement fixes, le déplacement de cette sonde peut se faire extrêmement rapidement puisque la commande du positionnement de ces éléments minoritaires est une commande électronique pouvant se faire par exemple par un balayage en ligne, en colonne ou autre. On n'est plus donc limité que par la vitesse de commande en blocage ou déblocage des diodes dans le cas où les interrupteurs contrôlables sont constitués par de telles diodes. Ceci permet de multiplier par plus de cent la vitesse d'analyse d'un faisceau d'ondes électromagnétiques hyperfréquence par rapport à la vitesse des procédés classiques les plus rapides.

On comprend également que l'invention pourra trouver de nombreuses applications immédiates qui ne sera pas limitée à la seule analyse du faisceau d'émission d'une antenne.

Par exemple, l'invention peut trouver application dans la « radiographie » en ondes hyperfréquence de tout corps soumis à un tel rayonnement, de telles « radiographies » trouvant leur application aussi bien dans l'industrie que dans le domaine médical et chirurgical par exemple.

Les résultats de l'analyse peuvent être traduits suivant des méthodes électroniques classiques connues de l'Homme de l'Art en tableaux de chiffres éventuellement exploitables par ordinateur, en courbes ou même en surface à trois dimensions.

En pratique, et de façon à permettre une mesure plus fine, le nombre des éléments « minoritaires » sera choisi égal à 1.

L'invention vise en outre un dispositif permettant la mise en œuvre du procédé susmentionné, ce dispositif se caractérisant en ce qu'il comprend :

— deux réseaux de fils croisés, par exemple sensiblement orthogonaux, de fils conducteurs formant une trame quadrillée de mailles juxtaposées,

— un tronçon de fils connectés dans chaque maille à un couple de deux fils conducteurs croisés différents d'une maille à une autre,

— un interrupteur tel qu'une diode sur chacun desdits tronçons, placée sensiblement au milieu de la partie du tronçon contrôlable parallèle au vecteur champ électrique de l'onde hyperfréquence,

— un commutateur électronique permettant d'alimenter séquentiellement à partir desdits réseaux successivement chacun desdits éléments ou d'un petit nombre d'entre eux pour le commander dans l'état zéro et tous les autres éléments dans l'état 1.

Selon une disposition préférée, les tronçons de fils forment un L dont la branche supportant l'interrupteur est parallèle au vecteur champ électrique de l'onde hyperfréquence et dont les extrémités sont reliées à deux fils conducteurs formant deux côtés de chaque maille.

Avantageusement, les fils conducteurs sont disposés selon deux réseaux de fils parallèles, orthogonaux d'un réseau à l'autre, respectivement de chaque côté d'une plaque support, avantageusement en matériau diélectrique, lesdits tronçons étant situés de l'un des côtés de ladite plaque et des trous formés à travers ladite plaque assurant la liaison électrique maille par maille de chaque tronçon avec l'un des fils conducteurs du réseau de fils situés de l'autre côté de la plaque.

L'invention et sa mise en œuvre apparaîtront plus clairement à l'aide de la description qui va suivre faite en référence aux dessins annexés donnant uniquement à titre d'exemple un mode de réalisation.

Dans ces dessins :

la figure 1 montre de façon schématique l'ensemble d'un dispositif permettant l'analyse d'un faisceau de rayonnement d'ondes électromagnétiques hyperfréquence, seul un fragment du panneau d'analyse ayant été représenté,

la figure 2 montre en coupe faite sensiblement selon le plan II-II de la figure 3 un fragment du panneau d'analyse,

la figure 3 montre dans la direction de la flèche III de la figure 2 un fragment du même panneau.

Selon le mode de réalisation et d'utilisation illustré aux dessins, on désire analyser le faisceau de rayonnement d'ondes électromagnétiques hyperfréquence émis par une antenne T. A cet effet, on dirige le faisceau émis par l'antenne T vers un panneau P conforme à l'invention permettant l'analyse point par point du faisceau comme il sera expliqué ci-après. Le panneau peut être placé à relativement faible distance devant l'antenne.

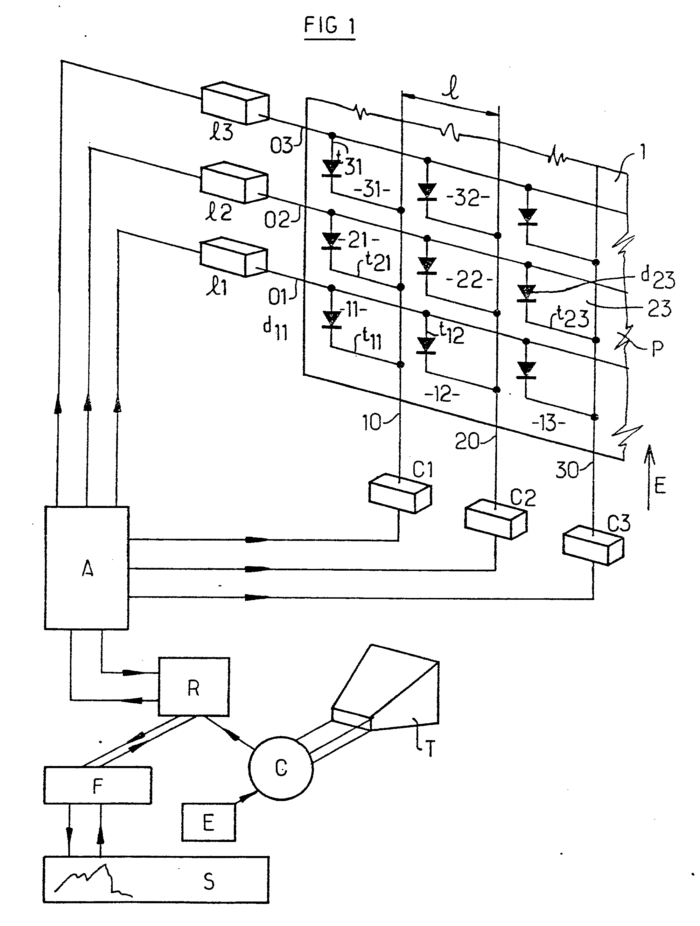

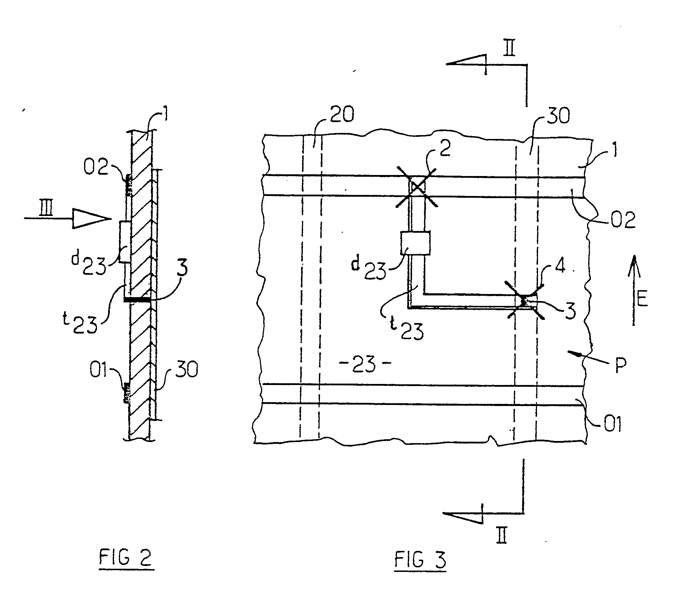

Le panneau P comprend deux réseaux de fils croisés, disposés selon l'exemple de réalisation illustré sensiblement orthogonalement ; ces fils conducteurs forment une trame quadrillée comme il apparaît à la figure 1. Un premier réseau de fils parallèles 01, 02, 03... est disposé d'un côté d'une plaque formant panneau diélectrique 1 (voir figure 2), tandis que le second réseau orthogonal au premier de fils parallèles 10, 20, 30... est disposé de l'autre côté de cette même plaque 1. Il n'y a donc pas de contact électrique direct entre ces fils qui peuvent être formés par exemple sur chaque face du panneau diélectrique 1 par la technique des circuits imprimés. A la figure 1, les points de croisement entre les fils tels que 02 et 10 par exemple ne sont donc pas des points de contact électriques de ces fils.

Les deux réseaux de fils orthogonaux divisent ainsi la surface du panneau P en mailles carrées que l'on peut repérer de proche en proche et de façon univoque par un nombre composé d'une première partie donnant le numéro de la ligne de rang supérieur formant une frontière de la maille et une deuxième partie donnant le numéro de la colonne de rang supérieur formant une frontière de la même maille. Ainsi, sont repérées à la figure les mailles 11, 12, 13... 21, 22... 31, 32...

Conformément à l'invention, dans chacune de ces mailles, on dispose un tronçon de fils tels que $t_{11}$, $t_{12}$... $t_{21}$... fils conducteurs qui relient une ligne d'un réseau à une colonne de l'autre réseau. Dans la construction précise illustrée à la figure 1, les liaisons électriques marquées par des points sont réalisées entre chaque tronçon portant la référence de la maille dans laquelle il est inclu avec la ligne et la colonne dont les numéros de rangs constituent les deux parties du nombre de la numérotation des mailles. Ainsi par exemple, le tronçon $t_{23}$ est compris dans la maille 23 et est relié à la ligne 02, et à la colonne 30, la maille 23 étant bordée par les lignes 01 et 02 (rang supérieur) et par les colonnes 20 et 30 (rang supérieur).

Les différents tronçons de fils t, tels que le tronçon $t_{23}$ par exemple sont disposés sur une face du panneau, par exemple sur la face qui porte le réseau des lignes 01, 02, etc. Ces tronçons peuvent être rapportés ou réalisés avantageusement comme les lignes par la technique des circuits imprimés. Le contact électrique des tronçons avec les lignes tels que matérialisés par un point à la figure 1 se fait aisément puisque ces fils sont dans le même plan sur la même face du panneau 1. Le contact électrique est matérialisé à la figure 3 par une croix repérée 2.

Les contacts électriques des tronçons avec les colonnes du réseau qui sont disposées de l'autre côté du panneau sont formés par des trous métallisés 3 (figures 2 et 3) qui traversent le panneau 1 permettant le contact électrique au point 4 comme repéré par la croix à la figure 3.

Ainsi, chaque tronçon de fils $t_{np}$ peut être connecté de façon univoque dans la maille np dans laquelle il est inclu à une ligne de fils de rang n et à une colonne de fils de rang p des deux réseaux orthogonaux.

Avantageusement, et comme repéré sur les dessins, les tronçons forment un L dont les branches occupent sensiblement le milieu des mailles.

Conformément à une caractéristique essentielle de l'invention, sur chaque tronçon $t_{np}$ est monté, avantageusement sensiblement vers le milieu du segment de tronçon parallèle à $\vec{E}$ un interrupteur, tel en particulier qu'une diode d qui peut être repérée par le même nombre que celui qui repère la maille considérée.

On comprend immédiatement que si l'on place sur chaque ligne du premier réseau un commutateur de ligne $l_1$, $l_2$, $l_3$, etc et sur chaque colonne de l'autre réseau un commutateur de colonne $c_1$, $c_2$, $c_3$, etc et que l'on relie ces commutateurs à un dispositif électronique de commande A, il est possible de faire passer dans chacun des tronçons un courant d'intensité voulue, et notamment de faire passer dans tous les tronçons des courants relativement forts de plusieurs milliampères correspondant sensiblement au courant de saturation des diodes d, à l'exception d'un ou d'un tout petit nombre localisé de tronçons dans lesquels on ne fera passer aucun courant en bloquant les diodes correspondantes par application d'une tension inverse, et inversement, on pourra appliquer une tension inverse de blocage des diodes de tous les tronçons, sauf à celle de l'un d'entre eux.

On décrira ci-après comment on peut utiliser le panneau de l'invention pour effectuer l'analyse du faisceau émis par l'antenne T, dont on a repéré en $\vec{E}$ le vecteur champ électrique.

Tous d'abord, pour avoir une bonne finesse de la mesure, on choisit de préférence le pas des mailles l inférieur à la longueur d'ondes du faisceau analysé, et de préférence inférieur au quart de cette longueur d'onde. Par exemple, dans le cas d'une analyse d'un faisceau émettant autour de 3 000 MHz, on adoptera avantageusement un pas de maille de l'ordre de 2 centimètres.

Dans un tel cas, on doit noter que tout tronçon de fil orienté parallèlement au vecteur champ électrique $\vec{E}$ et de longueur inférieure ou égale à la longueur d'onde critique $\lambda/2$ forme un dipôle résonnant qui interfère et réfléchit d'autant plus l'onde électromagnétique hyperfréquence incidente qu'il est grand. Dans ces conditions les tronçons de fil sur lesquels les diodes sont passantes réfléchiront de façon plus importante le faisceau hyperfréquence incident que les tronçons de fil sur lesquels les diodes sont bloquées et qui électromagnétiquement équivalent à deux dipôles de longueur moitié, plus « transparents » au faisceau qu'un dipôle de longueur double.

Si la mesure est faite en réflexion, on appliquera une tension inverse de blocage des diodes de tous les tronçons, sauf à celle du tronçon $t_{np}$ de la maille np. Dans cette maille pour laquelle la diode $d_{np}$ est passante, le dipôle formé par la partie parallèle au champ électrique E du tronçon $t_{np}$ induira un effet d'écho plus important sur le faisceau des ondes hyperfréquence émis que celui induit par les autres tronçons aux diodes bloquées qui apparaissent plus « transparents » pour le faisceau incident.

On place un panneau tel que P devant une antenne émettrice T. L'antenne est reliée à un émetteur E, un récepteur qui reçoit le signal en retour R et un circulateur C permettant la réception du signal d'écho après chaque période d'émission.

Le récepteur est relié à un appareil A comportant l'électronique de commande qui permet de faire varier successivement les tensions appliquées aux lignes 01, 02, etc et aux colonnes 10, 20, 30, etc par l'intermédiaire des commutateurs de lignes $l_1$, $l_2$, etc et de colonnes $C_1$, $C_2$, etc pour rendre conductrice successivement une seule diode $d_{np}$ du réseau. On peut utiliser un balayage en ligne et/ou en colonnes, par exemple analogue au balayage d'un écran de télévision.

Par exemple, pour rendre conductrice la diode $d_{23}$, du fil 02 vers le fil 30 en rendant toutes les autres diodes bloquées, on peut appliquer les tensions suivantes aux lignes et aux colonnes du réseau :

— tension sur la ligne 02 : 50 volts,
— tension sur la colonne 30 : 25 volts,
— tension sur les autres lignes du réseau $l_1$, $l_3$, etc : 0 volt,
— tension sur les autres colonnes du réseau, $c_1$, $c_2$, $c_4$, etc : 75 volts.

Il suffit alors d'enregistrer et mémoriser les signaux d'écho reçus par le récepteur en fonction de la position de chaque dipôle résonnant qui permet de localiser précisément le point du panneau sur lequel est reçu le faisceau analysé.

Les résultats peuvent être obtenus sous forme de tableaux de chiffres donnant notamment l'amplitude et la phase du signal reçu selon les coordonnées du point « réfléchissant » du panneau P. On peut également obtenir une image directe de ces valeurs par l'utilisation d'un circuit de mise en forme F attaquant un écran de visualisation S tel notamment qu'un tube cathodique.

De la description qui précède, il apparaît que la vitesse de balayage du panneau P n'est limitée que par le temps de réponse de blocage des diodes utilisées. Ces temps étant très courts (de l'ordre de quelques nanosecondes), le balayage peut être effectué très rapidement, la mesure étant plus de 100 fois plus rapide que celle autorisée par les moyens mécaniques susmentionnés.

L'écho ou champ rerayonné par le dipôle étant faible, on module avantageusement selon l'invention, le signal en appliquant à la diode du dipôle concerné une tension modulée en créneaux directe-inverse. Ainsi, le champ rerayonné est également modulé de même que le signal à l'entrée du récepteur, ce qui permet, par une détection synchrone de distinguer nettement le signal d'écho du « bruit de fond » parasite.

Pour effectuer une mesure rapide, on choisira une fréquence de modulation de la diode par exemple de 100 KHz, ce qui donne un temps suffisant de mesure de 1 milliseconde. Le déplacement du dipôle est effectué par commutation électronique, le nombre de mesures ponctuelles pouvant atteindre ainsi 1 000 par seconde.

Les applications de l'invention sont nombreuses.

L'invention permet tout d'abord de se substituer aux procédés connus susmentionnés d'analyse du faisceau d'émission d'une antenne.

L'invention permet également d'effectuer des « radios ou photographies » de corps divers soumis à un faisceau d'ondes électromagnétiques hyperfréquences. De telles radiographies peuvent notamment trouver leur application dans le domaine de la médecine et de la biologie. Le procédé extrêmement rapide de la mesure permet de faire des « instantanés » sans que le patient examiné soit soumis à une dose importante de rayonnements qui ne serait habituellement pas tolérable.

L'invention n'est nullement limitée au mode de réalisation illustré et décrit qui n'a été donné qu'à titre d'exemple, l'invention comprenant au contraire tous les équivalents techniques des moyens décrits ainsi que leurs combinaisons si celles-ci sont réalisées suivant son esprit et mises en œuvre dans le cadre de l'invention.

Ainsi, en particulier, si l'on veut obtenir un signal d'écho plus important, on peut grouper les éléments « minoritaires » bloqués par petit nombre d'éléments géographiquement localisés voisins donnant naissance à des signaux de mesure qui, dans certains cas, pourront être plus facilement exploitables en permettant de créer des images par taches plus étendues et plus fortes.

Ainsi, en particulier, si l'on veut faire l'analyse par point du faisceau incident par une mesure du champ électromagnétique à la transmission et non plus du champ rerayonné, il suffit d'inverser toutes les commandes de tension aux bornes des lignes et colonnes du panneau et de rendre ainsi le nouvel élément minoritaire créé, seul transparent au faisceau incident sur le panneau.

La mesure de ce champ transmis modulé et donc repéré comme précédemment est enregistrée par un récepteur supplémentaire placé derrière le panneau et donc distinct cette fois de l'antenne émettrice.

Ce dispositif utilisant le même réseau de fils que précédemment mais un récepteur supplémentaire ou éventuellement autant de récepteurs supplémentaires qu'il y a de mailles np transparentes successivement dans le réseau, et placés en regard de celles-ci, peut être plus intéressant pour effectuer des radiographies médicales ou biologiques par la plus grande sensibilité de mesure qu'il procure.

Egalement, on peut monter sur chaque tronçon $t_{np}$ plusieurs diodes en série $d_{np}$ de façon à avoir des dipôles encore plus petits donc transparents en régime de blocage des diodes.

## Revendications

1. Procédé d'analyse d'un faisceau de rayonnement d'ondes électromagnétiques hyperfréquence polarisé linéairement reçu sur une surface donnée et s'appliquant notamment à l'analyse d'un faisceau de telles ondes émis par une antenne émettrice hyperfréquence, caractérisé en ce qu'on place sur le trajet dudit faisceau un réseau en soi connu orienté parallèlement au vecteur champ électrique de l'onde incidente de fils conducteurs t parallèles au vecteur champ électrique de l'onde hyperfréquence émise et interrompus de distance en distance par des interrupteurs commandés tels en particulier que des diodes d présentant au moins deux états logiques (1, 0) tels que passant ou non passant, on organise ce réseau de façon à pouvoir commander simultanément le plus grand nombre desdits interrupteurs dans un premier état (1) et un nombre restreint et géographiquement groupé « minoritaires » des autres interrupteurs dans l'autre état (0), on fait varier séquentiellement et électroniquement la position desdits interrupteurs commandés dans l'état zéro pour balayer sensiblement toute la surface du réseau, et l'on reçoit et exploite le signal d'écho reçu sur un détecteur en repérant les caractéristiques significatives de cet écho en relation chaque fois avec la position desdits éléments en nombre restreint.

2. Procédé selon la revendication 1, caractérisé en ce qu'on module le courant traversant lesdits éléments minoritaires pour obtenir un signal d'écho modulé en correspondance.

3. Procédé selon la revendication 1, caractérisé en ce que le nombre des éléments minoritaires précité est égal à 1.

4. Procédé selon l'une des revendications précédentes, caractérisé en ce qu'on dispose lesdits éléments à l'intérieur d'un réseau de mailles croisées de pas inférieur à la longueur d'ondes du faisceau analysé et de préférence inférieur au quart de cette longueur d'onde.

5. Dispositif pour la mise en œuvre du procédé selon l'une des revendications précédentes, caractérisé en ce qu'il comprend :
— deux réseaux de fils croisés 01, 02... 10, 20... par exemple sensiblement orthogonaux de fils conducteurs formant une trame quadrillée de mailles juxtaposées,
— un tronçon t de fils connectés dans chaque maille à un couple de deux fils conducteurs croisés différents d'une maille à une autre,
— un élément interrupteur tel qu'une diode d sur chacun desdits tronçons,
— des commutateurs électroniques $l_1$, $l_2$, ...$c_1$, $c_2$, ... permettant d'alimenter séquentiellement à partir desdits réseaux successivement chacun desdits éléments d ou d'un petit nombre d'entre eux pour le commander dans l'état zéro et tous les autres éléments dans l'état 1.

6. Dispositif selon la revendication 5, caractérisé en ce que lesdits tronçons de fils t forment un L dont les extrémités sont reliées à deux fils conducteurs formant deux côtés de chaque maille.

7. Dispositif selon la revendication 5 ou la revendication 6, caractérisé en ce que ledit élément de résistance contrôlable ou interrupteur tel en particulier qu'une diode d est placé sensiblement à mi-longueur de chaque segment du tronçon t qui est parallèle au vecteur champ électrique de l'onde hyperfréquence incidente.

8. Dispositif selon l'une des revendications 5 à 7, caractérisé en ce que lesdits fils conducteurs 01, 02..., 10, 20, ... sont disposés selon deux réseaux de fils parallèles orthogonaux d'un réseau à l'autre respectivement de chaque côté d'une plaque support 1 avantageusement en matériau diélectrique, lesdits tronçons t étant situés de l'un des côtés de ladite plaque et des trous 3 formés à travers ladite plaque assurent la liaison électrique maille par maille de chaque tronçon avec l'un des fils conducteurs du réseau de fils situés de l'autre côté de la plaque.

9. A titre de produit industriel nouveau, un panneau d'analyse pouvant être utilisé dans la construction d'un dispositif selon l'une des revendications 5 à 8, caractérisé en ce qu'il est constitué de :
— deux réseaux de fils croisés 01, 02, ...10, 20, ... par exemple sensiblement orthogonaux de fils conducteurs une trame quadrillée de mailles juxtaposées,
— un tronçon t de fils connecté dans chaque maille à un couple de deux fils conducteurs croisés différents d'une maille à une autre,
— un élément interrupteur tel qu'une diode d sur chacun desdits tronçons.

10. Panneau d'analyse selon la revendication 9, caractérisé en ce que lesdits tronçons de fils et lesdits éléments de résistance contrôlables sont agencés comme indiqué dans l'une quelconque des revendications 6 à 8.

**Claims**

1. Method of analysing a linearly polarized microwave radiation beam received on a given surface and applicable in particular to the analysis of a beam of such waves emitted by a microwave transmission aerial, characterised in that there is placed, in the path of said beam, a network known per se, oriented parallel to the electric field vector of the incident wave, of conductive wires t which are parallel to the electric field vector of the transmitted microwave and interrupted at intervals by controlled circuit breakers such as, in particular, diodes d having at least two logical states (1, 0), such as conducting and non-conducting, this network is organized so that it is possible to control simultaneously the greatest number of said circuit breakers in a first state (1) and a restricted and geographically grouped number of other, so-called « minority » circuit breakers in the other state (0), the position of said circuit breakers controlled in the zero state (0) is varied sequentially and electronically to sweep substantially over the whole surface of the network, and the echo signal received on a detector is received and exploited by registering the significant characteristics of this echo in relation, each time, to the position of said elements which are restricted in number.

2. Method according to claim 1, characterised in that the current passing through said minority elements is modulated so that a correspondingly modulated echo signal is obtained.

3. Method according to claim 1, characterised in that the number of aforesaid minority elements is equal to 1.

4. Method according to one of the preceding claims, characterised in that the said elements are placed inside a network of meshes in which the distance between the intersections is less than the wavelength of the beam to be analysed and preferably less than one quarter of this wavelength.

5. Device for carrying out the method according to one of the preceding claims, characterised in that it comprises :
— two intersecting networks of wires 01, 02... 10, 20..., the conductive wires intersecting, for example, substantially at rightangles to form a chequerboard grid of juxtaposed meshes,
— a portion t of wire connected in each mesh to a couple formed by two intersecting conductive wires which differ from one mesh to another,
— a circuit breaker element such as a diode d on each of said portions,
— electronic switches $l_1$, $l_2$, ... $c_1$, $c_2$... enabling each of said elements d or a small number of said elements to be supplied sequentially and successively from said networks so that each of said successive elements is controlled in the zero state and all the other elements are controlled in the 1 state.

6. Device according to claim 5, characterised in that the said portions of wire t are L-shaped with the ends thereof connected to two conductive wires which form the two sides of a mesh.

7. Device according to claim 5 or claim 6, characterised in that said element with controllable resistance or circuit breaker such as, in particular, a diode d is placed substantially at the middle of the length of that section of each portion t which extends parallel to the electric field vector of the incident microwave.

8. Device according to one of the claims 5 to 7, characterised in that the said conductive wires 01, 02... 10, 20, ... are arranged to form two networks of parallel wires arranged at rightangles to one another, the two networks being situated on either side of a supporting plate 1 which is advantageously made of a dielectric material, the said portions t being situated on one side of said plate, and apertures 3 traversing said plate so that in each mesh the portion t can establish electric connection with one of the conductive wires of the network of wires situated on the other side of the plate.

9. By way of novel industrial product, an analysis panel which may be used in the construction of a device according to one of the claims 5 to 8, characterised in that it comprises :
— two intersecting networks of wires 01, 02... 10, 20..., having the conductive wires intersect, for example, substantilly at rightangles to form a chequerboard grid of juxtaposed meshes,
— a portion t of wire connected in each mesh to a couple formed by two intersecting conductive wires which differ from one mesh to another,
— a circuit breaker element such as a diode d on each of said portions.

10. Analysis panel according to claim 9, characterised in that the said portions of wire and said controllable resistance elements are arranged as indicated in any one of claims 6 to 8.

**Patentansprüche**

1. Verfahren zur Analyse eines Strahlenbündels von linear polarisierten Mikrowellen, die auf einer gegebenen Oberfläche empfangen werden, wobei das Verfahren besonders bei der Analyse eines Bündels solcher emitierter Wellen angewendet wird, die durch eine Mikrowellensendeantenne emitiert werden, dadurch gekennzeichnet, daß auf der Bahn des Bündels ein an sich bekanntes Drahtgitter angeordnet ist, welches parallel zum elektrischen Feldvektor der Auftreffwelle liegt, und zwar von Leitungsdrähten t, die parallel zum elektrischen Feldvektor der imitierten Mikrowelle verlaufen und in Abständen durch gesteuerte Unterbrecher unterbrochen sind, wie insbesondere durch Dioden d, die mindestens zwei logische Zustände (1, 0) aufweisen, wie z. B. benutzt oder nicht benutzt, daß dieses Drahtgitter derart vorgesehen wird, daß man gleichzeitig die größere Anzahl dieser Unterbrecher in einen ersten Zustand (1) und eine beschränkte Anzahl und örtlich gruppierte « Minderheiten- » Anzahl der anderen Unterbrecher in den anderen Zustand (0) steuern kann, daß nacheinander und elektronisch die Position dieser gesteuerten Unterbrecher im Nullzustand verändert wird, um im wesentlichen die ganze Oberfläche des Drahtgitters zu bestreichen, und daß das auf einem Detektor empfangene Echosignal dadurch aufgenommen und verwertet wird, daß man die kennzeichnenden Merkmale dieses Echos jedesmal in Bezug auf die Position der in der Anzahl beschränkten Elemente ortet.

2. Verfahren nach Anspruch 1, dadurch gekennzeichnet, daß der durch die Minoritätenelemente verlaufende Strom reguliert wird, um ein entsprechend reguliertes Echosignal zu erhalten.

3. Verfahren nach Anspruch 1, dadurch gekennzeichnet, daß die Anzahl der vorgenannten Minoritätenelemente gleich 1 ist.

4. Verfahren nach einem der vorhergehenden Ansprüche, dadurch gekennzeichnet, daß diese Elemente innerhalb eines Drahtgitters von gekreuzten Maschen einer Weite unterhalb der Wellenlänge des analysierten Bündels und vorzugsweise unter einem Viertel dieser Wellenlänge angeordnet sind.

5. Vorrichtung zur Durchführung des Verfahrens nach einem der vorhergehenden Ansprüche, dadurch gekennzeichnet, daß :
— zwei Gitter gekreuzter Drähte 01, 02... 10, 20... z. B. im wesentlichen senkrecht zueinander angeordneter Leitungsdrähte, ein quadratisches Raster benachbarter Maschen bilden,
— ein Teilstück t von Drähten vorgesehen ist, die in jeder Masche mit einem Paar von zwei Leitungsdrähten verbunden sind, die von einer Masche zur anderen anders gekreuzt sind,
— ein Unterbrecherelement, wie z. B. eine Diode d, auf jedem dieser Teilstücke vorgesehen ist,
— elektronische Schalter $l_1$, $l_2$, ... $c_1$, $c_2$, ... von diesen Gittern aufeinanderfolgend die fortlaufende Versorgung jedes dieser Elemente d oder einer kleinen Anzahl unter ihnen gestatten, um das Element in den Nullzustand und alle anderen Elemente in den Zustand 1 zu steuern.

6. Vorrichtung nach Anspruch 5, dadurch gekennzeichnet, daß diese Drahtteilstücke t ein L bilden, dessen Enden mit zwei Leitungsdrähten verbunden sind, die zwei Seiten jeder Masche bilden.

7. Vorrichtung nach Anspruch 5 oder Anspruch 6, dadurch gekennzeichnet, daß das steuerbare Widerstandselement oder der Unterbrecher, wie insbesondere eine Diode d, im wesentlichen auf der halben Länge jedes Segmentes des Teilstückes t angeordnet ist, welches parallel zum elektrischen Feldvektor der einfallenden Mikrowelle verläuft.

8. Vorrichtung nach einem der Ansprüche 5 bis 7, dadurch gekennzeichnet, daß die genannten Leitungsdrähte 01, 02... 10, 20, ... gemäß zwei Gittern von parallelen Drähten, senkrecht von einem Gitter zum anderen auf jeder Seite einer Stützplatte 1 angeordnet sind, die vorteilhafterweise aus dielektrischem Material besteht, und daß die Teilstücke t, die auf einer Seite der Platte angeordnet sind, und durch diese Platte hindurchgehende Löcher 3 die elektrische Verbindung jedes Teilstückes von Masche zu Masche mit einem der Leitungsdrähte des Gitters von Drähten sicherstellen, die auf der anderen Seite der Platte angeordnet sind.

9. Analysentafel als neues industrielles Produkt, welche bei dem Aufbau einer Vorrichtung gemäß einem der Ansprüche 5 bis 8 benutzt werden kann, dadurch gekennzeichnet, daß sie aufgebaut ist aus :

— zwei Gittern gekreuzter Drähte 01, 02, ...10, 20, ...., beispielsweise im wesentlichen senkrechter Leitungsdrähte, welche ein quadratisches Raster benachbarter Maschen bilden,

— ein Drahtteilstück t, welches in jeder Masche mit einem Paar von zwei Leitungsdrähten verbunden ist, die von einer Masche zur anderen unterschiedlich gekreuzt sind,

— ein Unterbrecherelement, wie z. B. eine Diode d, auf jedem dieser Teilstücke.

10. Analysentafel nach Anspruch 9, dadurch gekennzeichnet, daß die Drahtteilstücke und die steuerbaren Widerstandselemente so angebracht sind, wie in einem der Ansprüche 6 bis 8 angegeben ist.

FIG 1

FIG 2

FIG 3